Europäisches Patentamt

European Patent Office

Office européen des brevets

(19)

(11) Veröffentlichungsnummer: **0 326 821**
**A1**

(12) # EUROPÄISCHE PATENTANMELDUNG

(21) Anmeldenummer: 89100426.9

(51) Int. Cl.4: **H05K 3/34 , B23K 1/00**

(22) Anmeldetag: 11.01.89

(30) Priorität: 01.02.88 DE 3802901

(43) Veröffentlichungstag der Anmeldung:
09.08.89 Patentblatt 89/32

(84) Benannte Vertragsstaaten:
CH DE FR GB IT LI

(71) Anmelder: Siemens Aktiengesellschaft Berlin und München
Wittelsbacherplatz 2
D-8000 München 2(DE)

(72) Erfinder: Schuster, Rudolf
Graf-Andechs-Strasse 8
D-8011 Heimstetten(DE)
Erfinder: Roderer, Helmut
Badstrasse 23
D-8190 Wolfratshausen(DE)
Erfinder: Mayinger, Franz, Prof. Dr.
Am Haselnussstrauch 18
D-8000 München 45(DE)

(54) **Einrichtung zur Behandlung von mit oberflächenmontierbaren Bauelementen bestückten Leiterplatten mittels Bestrahlung.**

(57) Eine erfindungsgemäße Einrichtung wird im wesentlichen durch den Einsatz von Infrarot-Strahlung als Lötofen, beispielsweise zum Reflow-Löten, verwendet; die Temperaturprofile wird durch den Einsatz eines Strahlungsschirmes (8) exakt hergestellt. Sobald die Strahlungsschirme (8) wirksam sind, ist die Energiezufuhr auf die Leiterplatte (1) unterbunden.

FIG 1

EP 0 326 821 A1

Siemens Aktiengesellschaft

Einrichtung zur Behandlung von mit oberflächenmontierbaren Bauelementen bestückten Leiterplatten mittels Bestrahlung

Die Erfindung betrifft eine Einrichtung zur Behandlung von Leiterplatten, die mit oberflächenmontierbaren Bauelementen bestückt sind. insbesondere für Reflow-Lötprozesse und Klebstoff-Aushärteverfahren.

Bei der Befestigung von oberflächenmontierbaren Bauelementen auf Leiterplatten werden verschiedene Verfahren angewandt. Unterteilt man grob in drei Verfahrensschritte, so wären hierbei das Plazieren, das Fixieren und das Herstellen der elektrisch leitenden Verbindung zwischen oberflächenmontierbarem Bauelement und Leiterplatte zu nennen. Das Plazieren geschieht mittlerweile fast ausnahmslos durch sogenannte Bestückautomaten. Das zum Durchführen der folgenden Verfahrensschritte notwendige Fixieren geschieht in der Regel durch eine oder mehrere Klebstoff-Verbindungen zwischen Bauteil und Leiterplatte. Die endgültige mechanisch tragende und elektrisch leitende Verbindung wird durch ein Lötverfahren hergestellt, wobei je nach Art des Bauteiles innerhalb der Gruppe der oberflächenmontierbaren Bauelemente nur bestimmte Verfahren anwendbar sind. Ein gattungsgemäßes Verfahren, daß mit Bestrahlung arbeitet, ist das Infrarot-Löten. Des weiteren können Klebstoffe durch Erwärmung, also beispielsweise durch Infrarot-Bestrahlung, oder durch Bestrahlung mittels UV-Strahlung ausgehärtet werden. Die auf dem Markt erhältlichen Apparaturen für derartige Prozesse. bei denen bestückte Leiterplatten in einem Behandlungsraum bearbeitet werden, sind in der Regel Lötkammern oder Lötöfen.

Speziell beim Infrarot-Löten im Durchlauf-, Tunnel- oder Kammerofen ist die für jedes Bauteil optimale Wärmebelastung durch deren verschiedene Größe und der entsprechend unterschiedlichen Wärmekapazität bisher nicht zuverlässig ein stellbar.

Der Erfindung liegt die Aufgabe zugrunde, eine Einrichtung zur Behandlung von mit oberflächenmontierbaren Bauelementen bestückten Leiterplatten mittels Bestrahlung zur Verfügung zu stellen, mit der die Belastung einer bestückten Leiterplatte durch Bestrahlung präzise eingestellt werden kann.

Die Lösung dieser Aufgabe wird durch den kennzeichnenden Teil des Anspruches 1 wiedergegeben.

Der Erfindung liegt die Erkenntnis zugrunde, daß die thermische Trägheit einer Beheizungseinrichtung mittels Infrarot-Bestrahlung in einfacher Weise durch die zeitweilige Anordnung eines Bestrahlungsschirmes zwischen Strahlungsquelle und Leiterplatte behoben werden kann. Die Leiterplatte ist damit bezüglich der Strahlung, die von den Strahlungsquellen ausgeht, die meist in Form von Strahlungsschirmen vorliegen, teilweise oder komplett im Schatten des Strahlungsschirmes. Damit ist die Energiezufuhr, die bei entsprechenden Behandlungseinrichtungen zum überwiegenden Teil durch Strahlung erfolgt für diesen Teil der Leiterplatte schlagartig unterbunden und die Leiterplatte wird im wesentlichen nur durch die Wärmeübertragung durch Konvektion beeinflußt. Somit kann das Temperaturprofil für die Leiterplatte örtlich und zeitlich exakt differenziert werden. Außerdem können An- bzw. Auslaufphasen beim Ein- oder Ausfahren der Leiterplatte in den Behandlungsraum bzw. beim Ein- oder Ausschalten der Strahlungsquellen ausnahmslos umgangen oder optimiert werden.

Steht bei einer erfindungsgemäßen Einrichtung eine Wärmebehandlung von Leiterplatten im Vordergrund, so ist der Einsatz von Infrarot-Strahlung zur Erwärmung am besten geeignet. Reflow-Lötprozesse und Kleberaushärteprozesse, die unter Temperatureinwirkung von statten gehen, können hiermit in vorteilhafter Weise durchgeführt werden.

Eine erfindungsgemäße Einrichtung zur Behandlung von Leiter platten mittels Bestrahlung ist unter Einsatz von UV-Strahlung in der Lage UV-aushärtende Klebstoffe zu bearbeiten. Hiermit werden beispielsweise Bauelemente auf Leiterplatten aufgeklebt, die anschließend in einem Schwallbad gelötet werden.

Eine vorteilhafte Ausgestaltung der Erfindung sieht vor, daß der Abstand zwischen Strahlungquelle und Leiterplatte varrierbar ist. Da die Leiterplatten mit unterschiedlichsten Bauelementen bestückt sein können, ist es vorteilhaft, daß die Intensität der Strahlung an den Bauelementen bzw. auf der Leiterplattenoberfläche in bestimmten Grenzen variiert werden kann. Die exakt differenzierte Einstellung des Temperaturprofiles geschieht mittels des Einsatzes des Strahlungsschirmes.

Eine weitere mögliche Ausgestaltung ist durch die Variation der Leistung der Strahlungsquelle gegeben. Die variable Leistung ist ein Mittel dazu, die Temperaturkurve grob vorzugeben. Die Trägheit der mit relativ großer Wärmekapazität versehenen Strahlungsquelle kann wiederum durch den Einsatz des Strahlungsschirmes behoben werden.

Die besten Ergebnisse lassen sich erzielen, wenn die Bestrahlung der Leiterplatte senkrecht von oben oder von unten geschieht, da hierbei die Wirkung der Strahlung, die senkrecht auftrifft, am größten ist.

Eine äußerst einfache Realisierung des Strahlungsschirmes ergibt sich dadurch, daß der Strahlungsschirm ständig zwischen Leiterplatte und Strahlungsquelle angeordnet ist, jedoch zeitweise für die Strahlung durchlässig ist. Somit kann anhand einer entsprechenden Steuerung zur Erzielung eines vorgegebenen Temperaturprofiles auf der Leiterplatte die von der Strahlungsquelle ausgehende Strahlung im einen Fall bis zur Leiterplatte gelangen oder im anderen Fall vom Strahlungsschirm zurückgehalten werden. Dazwischen sind alle beliebigen Zustellungen möglich.

Eine besonders vorteilhafte Ausgestaltung der Erfindung sieht vor, daß der Strahlungsschirm in Form einer Jalousie vorliegt. Diese Jalousie ist in mehrere Elemente unterteilt und kann durch gleichzeitiges Verdrehen der einzelnen Elemente für die Strahlung durchlässig gemacht werden oder im anderen Fall, in dem die einzelnen Elemente einen geschlossenen Strahlungsschirm bilden, für einen Strahlungsschatten auf der Leiterplatte sorgen. Je nach Ausführung der Jalousie kann diese auch durchlässig für seitlich einfallende Strahlung sein. Dies ist abhängig von der Größe der Leiterplatten und der Fläche der Strahlungsquellen bzw. von den Abständen der einzelnen Teile voneinander.

Es hat sich als besonders vorteilhaft herausgestellt, daß die Behandlung im Behandlungsraum an stationären Leiterplatten vorgenommen wird. Das heißt, daß beispielsweise kein Durchlaufofen, sondern ein Chargenofen vorliegt. Die besonderen Vorteile liegen in der kleineren Bauweise eines derartigen Aggregates, in der einfacheren Handhabung durch den Wegfall von Temperaturregelungen verschiedener Zonen und in der Ausschaltung von Störeinflüssen durch mehr oder weniger offene Schleusen, wie es bei Durchlauföfen der Fall ist. Somit kann während der Behandlung ein bestimmtes vorgegebenes Temperaturprofil in einfacher Weise und ohne aufwendige Regelung nachgefahren werden.

Eine zusätzliche Ausgestaltung besteht darin, daß die Chargengrößen, das heißt die Größen der Leiterplatten von Charge zu Charge annähernd konstant sind. Dies hat den Vorteil, daß die Behandlungseinrichtung optimal genutzt werden kann. Ein Behandlungsraum der in der Regel auf die maximale Leiterplattengröße ausgelegt ist, wird für den Fall, daß kleinere Leiterplatten behandelt werden sollen, gleichzeitig mit einer Mehrzahl von kleineren Leiterplatten, die insgesamt einer großen Leiterplatte entsprechen, chargiert. Somit ist die zu erwärmende Masse bei einem Behandlungsvorgang von Charge zu Charge annähernd konstant und die Einrichtung wird bei optimalem Wirkungsgrad betrieben.

Im folgenden wird anhand schematischer Zeichnungen ein Ausführungsbeispiel beschrieben.

Fig. 1 zeigt einen Lötofen mit Transporteinrichtungen im Querschnitt,

Fig. 2 zeigt zwei mögliche Temperaturprofile, die mit einer entsprechenden Einrichtung nachgefahren werden können.

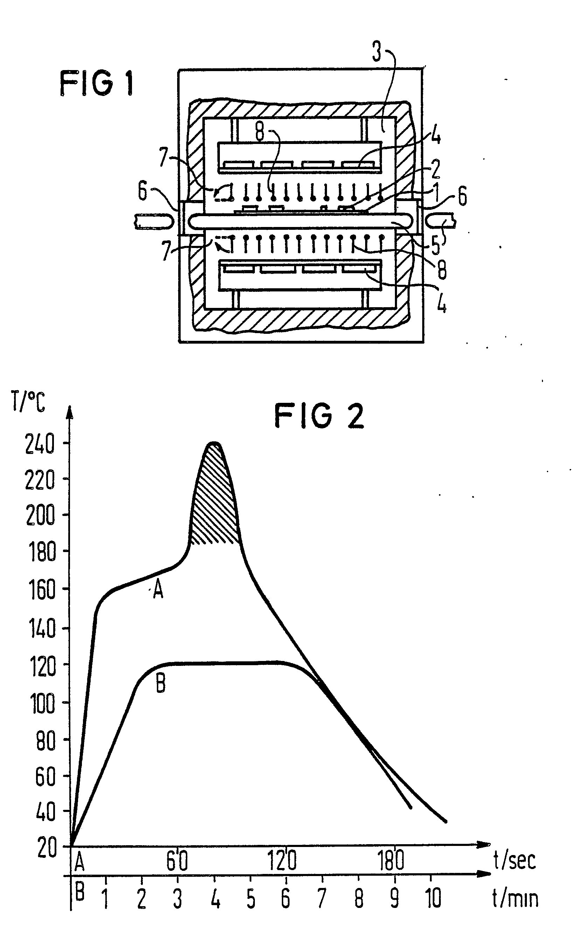

In der Fig. 1 wird ein Lötofen, der mit Infrarot-Bestrahlung arbeitet im Schnitt dargestellt. Es sind in diesem Fall eine Leiterplatte 1 mit Bauelementen 2 in einem Behandlungsraum 3 stationär angeordnet und werden von Infrarot-Strahlern 4 beheizt. Zum Chargieren des Ofens ist die Fördereinrichtung 5 in Form eines Förderbandes vorhanden. Die Schleusen 6 sorgen für ein Abdichten des Behandlungsraumes 3 während der Behandlung. Die Strahlungsschirme 8, die ebenso wie die Strahlungsquellen 4 bezogen auf die Leiterplatte 1 senkrecht von oben und von unten angeordnet sind, können durch Umklappen der einzelnen Elemente in der Bewegungsrichtung 7 zu einem für die Strahlung undurchlässigen Strahlungsschirm ausgebildet werden. So wie in der Zeichnung dargestellt sind die in Form einer Jalousie vorliegenden Strahlungsschirme 8 zum ungehinderten Passieren der Strahlung eingestellt. Mit der Möglichkeit die Strahlungsschirme 8 als Jalousie zu öffnen oder zu Schließen kann die Bestrahlung der Leiterplatte 1, auf der beispielsweise ein Reflow-Lötprozeß ablaufen soll, zeitlich exakt gesteuert werden. Um auf der Leiterplatte 1 einen genau vorgegebenen Schatten zu erzielen, können die Strahlungsschirme 8 entsprechend ausgebildet werden.

Als eine äquivalente Möglichkeit der Ausbildung der Strahlungsschirme 8 wäre beispielsweise auch ein innerhalb des Behandlungsraumes 3 verfahrbarer Rolladen denkbar.

In der Fig. 2 ist einmal für den Fall A eine Temperaturkurve für einen Reflow-Lötprozeß und zum anderen im Fall B eine Temperaturkurve für einen thermisch aushärtenden Klebstoff dargestellt. Zum Nachfahren derartiger Temperaturprofile, wobei im Fall A ganz besonders auf die Ausprägung der kurzzeitigen Temperaturüberhöhung in dem Temperaturbereich zwischen 180° C und 240° C zu achten ist, hat sich der Einsatz eines oder mehrerer Strahlungsschirme 8 sehr gut bewährt. Die Temperaturkurven können mit ihren verschiedenen Aufheizgeschwindigkeiten und mit Haltepunkten oder kurzzeitigen Temperaturüberhöhungen exakt nachgefahren werden. Da der wesentliche Anteil der Beheizung durch die Infrarot-Strahlung direkt geschieht, hat der Teil der Wärmeübertragung, die durch Konvektion abläuft, einen untergeordneten Stellenwert. Der Einfall der Strahlung und somit auch die Erwärmung der Bauelemente 2 bzw. der Leiterplatte 1 kann durch die Strahlungsschirme 8 präzise gesteuert werden.

## Ansprüche

1. Einrichtung zur Behandlung von mit oberflächenmontierbaren Bauelementen bestückten Leiterplatten mittels Bestrahlung, insbesondere für Reflow-Lötprozesse, mit einem Behandlungsraum und einer darin angeordneten Fördereinrichtung zum Transport der Leiterplatten, sowie mindestens einer in einem vorgebbaren Abstand zu den Leiterplatten angeordneten Strahlungsquelle, **dadurch gekennzeichnet**, daß mindestens ein Strahlungsschirm (8) zur Erzeugung eines zumindest partiellen Strahlungsschattens auf der Leiterplattenoberfläche zwischen Strahlungsquelle (4) und Leiterplatte (1) angeordnet ist.

2. Einrichtung nach Anspruch 1, **dadurch gekennzeichnet**, daß zur Behandlung Infrarotstrahlung eingesetzt wird.

3. Einrichtung nach Anspruch 1, **dadurch gekennzeichnet**, daß zur Behandlung UV-Strahlung eingesetzt wird.

4. Einrichtung nach einem der vorhergehenden Ansprüche, **dadurch gekennzeichnet**, daß der Abstand zwischen Strahlungsquelle (4) und Leiterplatte (1) variierbar ist.

5. Einrichtung nach einem der vorhergehenden Ansprüche, **dadurch gekennzeichnet**, daß die Leistung der Strahlungsquelle (4) variierbar ist.

6. Einrichtung nach einem der vorhergehenden Ansprüche, **dadurch gekennzeichnet**, daß die Strahlungsquellen (4) annähernd senkrecht von oben und/oder von unten auf die Leiterplatte (1) strahlen.

7. Einrichtung nach einem der vorhergehenden Ansprüche, **dadurch gekennzeichnet**, daß der Strahlungsschirm (8) zumindest zeitweise für die Strahlung durchlässig ist.

8. Einrichtung nach Anspruch 7, **dadurch gekennzeichnet**, daß der Strahlungsschirm (8) in Form einer Jalousie dargestellt ist.

9. Einrichtung nach einem der vorhergehenden Ansprüche, **dadurch gekennzeichnet**, daß die Leiterplatte (1) während der Behandlung stationär ist.

10. Einrichtung nach Anspruch 9, **dadurch gekennzeichnet**, daß die gesamte Größe der zu einer Behandlung in den Behandlungsraum (3) eingebrachten Leiterplatten (1), unabhängig von der einzelnen Größe einer Leiterplatte, konstant ist.

FIG 1

FIG 2

**Europäisches Patentamt**

# EUROPÄISCHER RECHERCHENBERICHT

Nummer der Anmeldung

EP 89 10 0426

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-1 565 070 (SIEMENS AG) <br> * Seite 4, Absatz 3; Seite 5, Zeile 25 - Seite 6, Zeile 13; Figur * <br> --- | 1-2,9 | H 05 K 3/34 <br> B 23 K 1/00 |
| A | DE-B-1 279 150 (TELEPHONBAU UND NORMALZEIT GmbH) <br> * Spalte 3, Zeilen 5-20; Figur 2 * <br> --- | 2,6 | |
| A | US-A-3 849 063 (J.E. EICHENLAUB) <br> * Spalte 5, Zeilen 15-18; Figur 1 * <br> ----- | 7-8 | |

**RECHERCHIERTE SACHGEBIETE (Int. Cl.4)**

H 05 K
B 23 K
B 29 C
F 27 D

**Der vorliegende Recherchenbericht wurde für alle Patentansprüche erstellt**

| Recherchenort | Abschlußdatum der Recherche | Prüfer |
|---|---|---|
| DEN HAAG | 09-05-1989 | SCHUERMANS N.F.G. |

EPO FORM 1503 03.82 (P0403)

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument